# EUROPEAN PATENT APPLICATION

(11) **EP 2 587 649 A1**
(43) Date of publication of application: **01.05.2013**
(21) Application number: 12763752.8
(22) Date of filing: 28.03.2012
(51) Int. Cl.: H02M 3/07

(54) **CONTROL SIGNAL GENERATING CIRCUIT, CHARGE PUMP DRIVE CIRCUIT, CLOCK DRIVER, AND METHOD OF DRIVING CHARGE PUMP**

(30) Priority: 30.03.2011 JP 2011076588
(71) Applicant: Asahi Kasei Microdevices Corporation, Tokyo 101-8101 (JP)
(72) Inventor: MATSUOKA, Daisuke, Tokyo 101-8101 (JP); YAMAMOTO, Ryuzo, Tokyo 101-8101 (JP)
(74) Representative: HOFFMANN EITLE
(86) International application number: PCT/JP2012/002165
(87) International publication number: WO 2012/132439

(57) **Abstract**

There is provided a control signal generating circuit which generates a control signal which can keep down the switching current and reduce the switching noise. A control signal generation circuit which generates a control signal for control of a gate of a PMOS transistor is comprised of a switch which is connected to a constant current source and a gate of the PMOS transistor and which is controlled based on an input signal and a switch which is connected to a constant current source and a gate of the PMOS transistor and which is controlled based on an input signal and a control signal. Further, the voltage value of the control signal is made to change by a slant based on the input signal and the control signal slant is switched so as to become smaller after the voltage value of the control signal exceeds the threshold value of the MOS transistor compared with when the voltage value of the control signal is equals to or less than the threshold value of the MOS transistor.

## Description

### Technical Field

The present invention relates to a control signal generation circuit , a charge pump drive circuit, a clock driver, and a drive method of a charge pump which can suppress switching noise.

### Background Art

It is known that a charge pump circuit generates switching noise. Switching noise occurs due to an on/off current IDS due to a switching operation (hereinafter, referred to as the "switching current") suddenly flowing to a capacitor which charges and discharges a charge pump circuit.
The magnitude of the switching noise is proportional to the amount of change of the switching current IDS, that is, the switching current IDS differentiated by time, i.e., dIDS/dt.

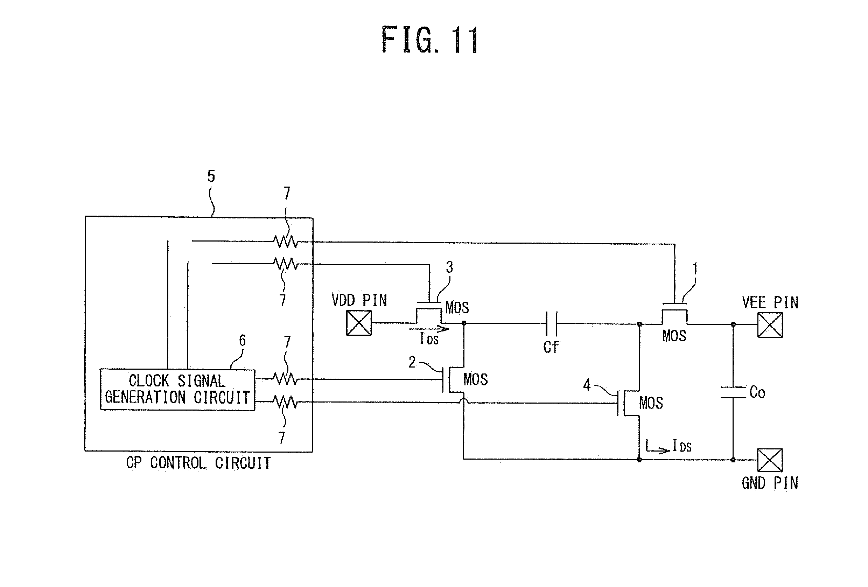

FIG. 11 is a view which shows a conventional charge pump drive circuit which prevents the sudden flow of a switching current IDS at the capacitor at the time of a switching operation.
The drive circuit which is illustrated is comprised of a steps-down charge pump circuit which has a capacitor Cf which stores and transfers a charge, a capacitor Co which stores a charge which is transferred from the capacitor Cf, and MOS transistors 1 to 4 and of a charge pump (CP) control circuit 5 which controls the gate voltages of the MOS transistors 1 to 4.
The CP control circuit 5 includes a clock signal generation circuit 6 which generates a clock and resistance elements 7 for blunting the rising edge waveform and trailing edge waveform of the clock. Note that, a control circuit for such a charge pump circuit is, for example, described in Patent Document 1.

The CP control circuit 5 which is shown in FIG. 11 inserts resistance elements 7 at the gate input nodes of the MOS transistors which charge and discharge the capacitors Cf, Co so as to reduce the rising edge through rates or trailing edge through rates of the gate voltages VG of the MOS transistors 1 to 4. The through rates can be reduced by moderating the on/off operations of the switches of the MOS transistors 1 to 4 and suppressing the sudden flow of switching current IDS at the capacitors Cf, Co.

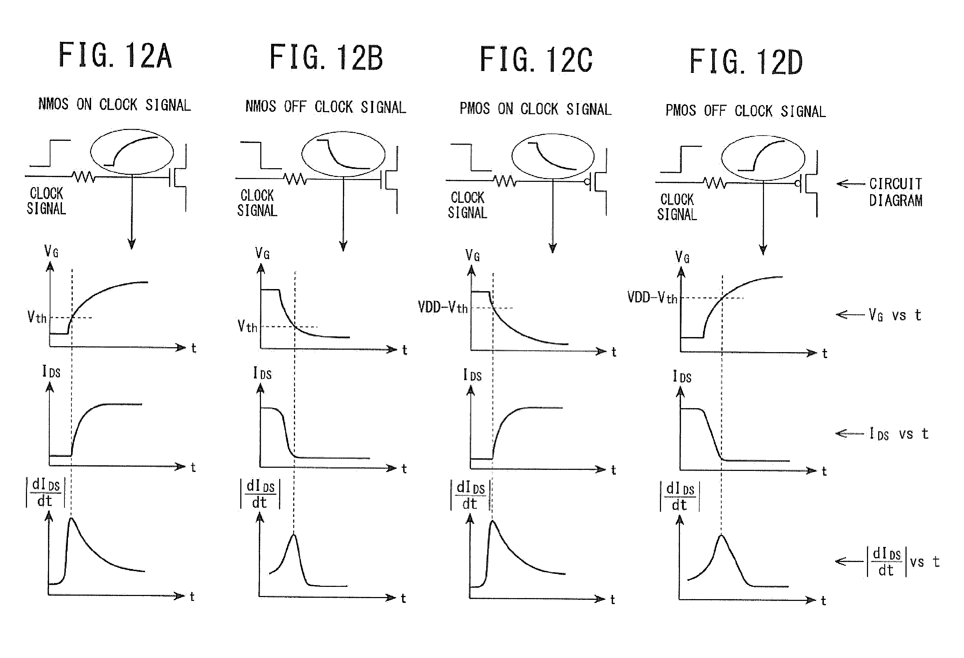

FIG. 12 is a view which shows the relationship of the on and off states of the NMOS transistors and PMOS transistors of the MOS transistors 1 to 4 which are shown in FIG. 11, the waveform of the clock signal which is generated by the clock signal generation circuit 6, the waveform of the clock signal after passing through a resistance element 7, the gate voltages VG of the NMOS transistors and the PMOS transistors, the switching current IDS, and the switching current IDS differentiated by time, that is, dIDS/dt.

In each of FIGS. 12A to 12D, the topmost row shows waveforms of a clock signal which is input to an MOS transistor before_passing through a resistance element 7 and after passing through a resistance element 7. Further, the next row shows the waveform of the gate voltage VG (waveform after passing through a resistance element 7) . The next row shows the waveform of the switching current IDS which flows between the source and drain of the MOS transistor, and the bottommost row shows the time differential waveform of the switching current IDS.

FIG. 12A shows the above waveforms when an NMOS transistor is on, while FIG. 12B shows the above waveforms when an N-type MOS transistor is off. FIG. 12C shows the above waveform when a PMOS transistor is on, while FIG. 12D shows the above waveform when a P-type MOS transistor is off.
For example, as shown in FIG. 12D, consider the case where a PMOS transistor is off. At this time, if the clock signal changes from L →H, the clock signal after passing through a resistance element 7, that is, the gate voltage VG, gently rises. Along with this, the switching current IDS gently falls. If the gate voltage VG rises to VDD-Vth, the PMOS transistor turns off. Here, the threshold voltage Vth is the threshold voltage of the MOS transistor.

Further, in FIG. 12C as well, the clock signal is used to similarly turn a PMOS transistor on, while in FIG. 12A and FIG. 12B as well, the clock signal is used to similarly turn a PMOS transistor on and off.
According to such a charge pump drive circuit, the clock signal after passing through the resistance element 7, that is, the gate voltage, becomes gentler. Along with this, the change along with time of the switching current IDS becomes gentler, so the time differential dIDS/dt of the switching current IDS is suppressed near the threshold value where the MOS transistor turns on and off and the switching noise is reduced.

According to FIG. 12, it is learned that in an MOS transistor, when the gate voltage passes near the threshold voltage, the amount of change of the switching current becomes the greatest, so that the smaller the change in the gate voltage near the threshold voltage, the smaller the amount of change of the current.
In the charge pump drive circuit which is shown in FIG. 11, in both the NMOS transistors and the PMOS transistors, the change in the gate voltage at the time of turning them off is small, so that the amount of change of the current is suppressed and the switching noise can be made smaller.

### Citations List

### Patent Document

Patent Document 1: JP 2005-192350 A

### Summary of Invention

### Problem to be Solved

However, in the above-mentioned conventional charge pump drive circuit, the change of the gate voltage near the threshold voltage at the time of turning on the MOS transistors continues to be larger than when off. For this reason, there is room for further study for keeping down the switching noise in the overall operation of MOS transistors.
The present invention was made in consideration of the above point and has as its object the provision of a control signal generation circuit which generates a control signal which can further keep down the switching current and reduce the switching noise and a charge pump drive circuit, a clock driver, and a drive method of a charge pump.

### Solution to the Problem

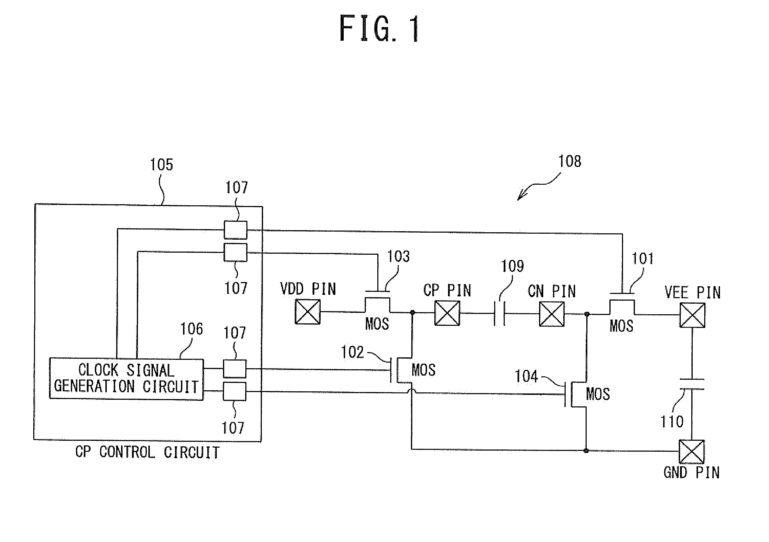

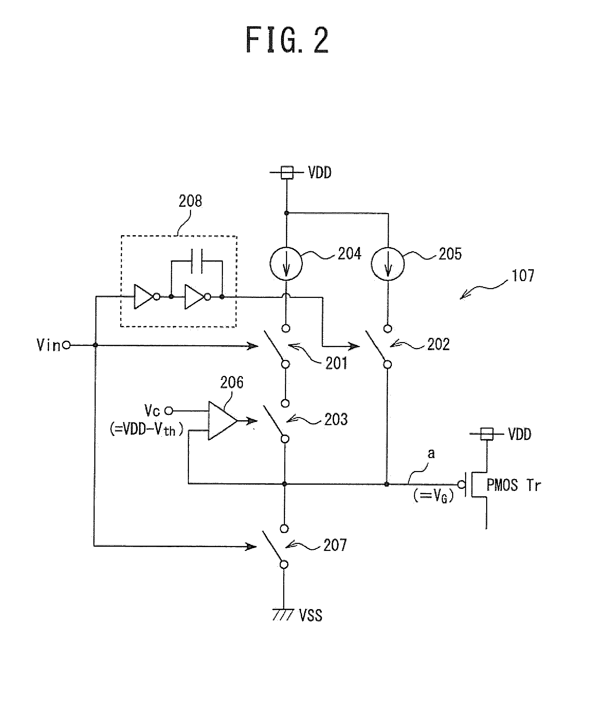

To solve the problem which is explained above, a control signal generation circuit of one aspect of the present invention is a control signal generation circuit which generates a control signal for controlling a gate of an MOS transistor (for example, the control signal generation circuit 107 which is shown in FIG. 1, FIG. 2, FIG. 4, FIG. 6, and FIG. 8), wherein the circuit is provided with a first switching part which is connected to a current source (for example, constant current source 205) and gate and which is controlled based on an input signal (for example, Vin shown in FIG. 2) (for example, the switch 202 which is shown in FIG. 2) and a second switching part which is connected to the current source (for example, the constant current source 204 which is shown in FIG. 2) and gate and which is controlled based on an input signal and control signal (for example, the switches 201, 203 which are shown in FIG. 2), a voltage value of the control signal changes based on the input signal, and a slant of the voltage value with respect to time is switched to become smaller after the voltage value exceeds a threshold voltage of the MOS transistor compared with when the voltage value equals to or less than the threshold voltage of the MOS transistor..

According to this aspect, it is possible to make the change of the switching current of an MOS transistor gentler before and after the timing of application of the threshold voltage to the MOS transistor in the charge pump circuit. For this reason, it is possible to reduce the switching noise of the charge pump circuit.
Further, the control signal generation circuit of one aspect of the present invention may comprise the above invention wherein the first switching part is provided with a first switch which is controlled on and off by an input signal (for example, the switch 202 which is shown in FIG. 2) and the second switching part is provided with a second switch which is controlled on and off by an input signal (for example, the switch 201 which is shown in FIG. 2) and the output control part which controls the current which flows to the second switch based on the control signal (for example, the switches 203, 206 which are shown in FIG. 2).

Further, the control signal generation circuit of one aspect of the present invention may comprise the above invention wherein the current source (for example, the constant current sources 204, 205 which are shown in FIG. 2) supplies a current of a value equal to the first switch and second switch.
Further, the control signal generation circuit of one aspect of the present invention may comprise the above invention wherein the current source is provided with a first current source which supplies a current to the first switch (for example, the constant current source 205 which is shown in FIG. 2) and a second current source which supplies a current, different in value from the current which is supplied by the first current source, to the second switch (for example, the constant current source 204 which is shown in FIG. 2) .

Further, the control signal generation circuit of one aspect of the present invention may comprise the above invention wherein the output control part is provided with a comparator which compares a voltage value of the control signal and a threshold value of an MOS transistor (for example, the comparator 206 which is shown in FIG. 2) and a third switch which is controlled on/off by the results of comparison of the comparator (for example, the switch 203 which is shown in FIG. 2).
Further, the control signal generation circuit of one aspect of the present invention may comprise the above invention wherein the third switch stops the flow of current to the second switch gradually when the MOS transistor changes from an on state to an off state.

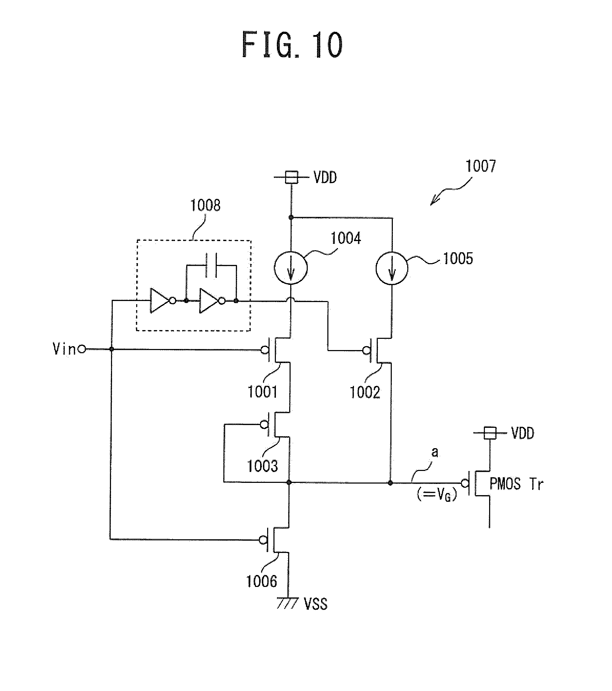

Further, the control signal generation circuit of one aspect of the present invention may comprise the above invention wherein the third switch supplies current which had been stopped to the second switch when the MOS transistor changes from an off state to an on state.
Further, the control signal generation circuit of one aspect of the present invention may comprise the above invention wherein the output control part is provided with a diode (for example, the switch 1003 which is shown in FIG. 10).

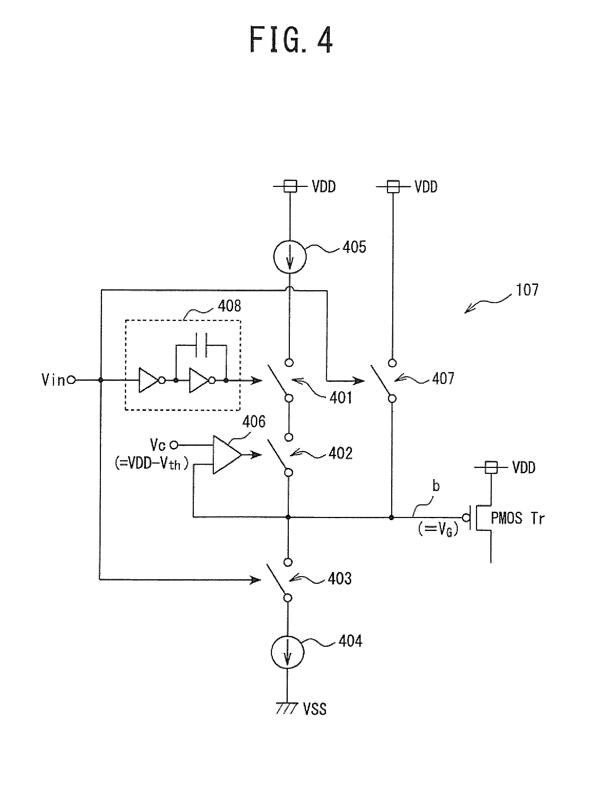

Further, the control signal generation circuit of one aspect of the present invention may comprise the above invention wherein the circuit is further provided with a delay part which generates a delay signal which is obtained by delaying an input signal (for example, the delay part 208 which is shown in FIG. 2) and the first switching part can supply current to the gate in accordance with the delay signal.
Further, the control signal generation circuit of one aspect of the present invention may comprise the above invention wherein the circuit is further provided with a delay part which generates a delay signal which is obtained by delaying an input signal (for example, the delay part 408 which is shown in FIG. 4) and the second switching part can supply current to the gate in accordance with the delay signal.

The charge pump drive circuit of one aspect of the present invention is characterized by being provided with at least one control signal generation circuit (for example, the control signal generation circuit 107 which is shown in FIG. 1), at least one MOS transistor (for example, the MOS transistor 101 etc. which is shown in FIG. 1), and a capacitance element which is charged and discharged by the MOS transistor (for example, the capacitor 109 which is shown in FIG. 1) . The clock driver of one aspect of the present invention is characterized by being provided with the above control signal generation circuit and driving an MOS transistor which is provided later than the control signal generation circuit based on the clock signal which is output from the control signal generation circuit.

The drive method of a charge pump of one aspect of the present invention is a drive method of a charge pump which drives a charge pump which has at least one MOS transistor and a capacitance element which is charged and discharged by the MOS transistor, characterized by generating a control signal which changes by a slant based on the input signal and whereby when the input signal exceeds a threshold value of the MOS transistor, the slant is switched to a smaller value compared to when the input signal equals to or less than a threshold value of the MOS transistor and by supplying current to a gate of the MOS transistor based on the input signal and the control signal.

### Advantageous Effect of Invention

According to the above aspect, it is possible to provide a control signal generation circuit which can make a change of a switching current of an MOS transistor gentler before and after the timing at which the threshold voltage is supplied to the MOS transistor inside of the charge pump circuit and reduce the switching noise of the charge pump circuit and to provide a charge pump drive circuit, clock driver, and drive method of a charge pump.

### Brief Description of the Drawings

FIG. 1 is a view for explaining a charge pump drive circuit of a first embodiment of the present invention.
FIG. 2 is a view for explaining the configuration of a control signal generation circuit which outputs a control signal for turning a PMOS transistor of the first embodiment of the present invention.
FIG. 3 is a view for explaining the operation of the control signal generation circuit which is shown in FIG. 2.
FIG. 4 is a view for explaining the configuration of a control signal generation circuit which outputs a control signal for turning a PMOS transistor of the first embodiment of the present invention.
FIG. 5 is a view for explaining the operation of the control signal generation circuit which is shown in FIG. 4.
FIG. 6 is a view for explaining the configuration of a control signal generation circuit which outputs a control signal for turning an NMOS transistor off in the first embodiment of the present invention.
FIG. 7 is a view for explaining the operation of a control signal generation circuit 107 which is shown in FIG. 6.
FIG. 8 is a view for explaining the configuration of a control signal generation circuit 107 which outputs a control signal for turning an PMOS transistor on.
FIG. 9 is a view for explaining the operation of the control signal generation circuit 107 which is shown in FIG. 8.
FIG. 10 is a view for explaining the configuration of the control signal generation circuit of a second embodiment.
FIG. 11 is a view which shows a conventional charge pump drive circuit.
FIG. 12 is a view which shows a clock signal etc. of the MOS transistors 1 to 4 which are shown in FIG. 11.

### Description of Preferred Embodiments

Below, a control signal generation circuit and a charge pump drive circuit which is provided with a control signal generation circuit of first and second embodiments of the present invention will be explained.

### First Embodiment

### Charge Pump Drive Circuit

FIG. 1 is a view for explaining a charge pump drive circuit of the first embodiment. The charge pump drive circuit of the first embodiment is comprised of a step-down charge pump circuit 108 which is provided with a capacitor 109 which stores and transfers charges, a capacitor 110 which stores a charge which is transferred from the capacitor 109, and MOS transistors 101 to 104 and a charge pump (CP) control circuit 105 which charges and discharges the capacitors 109, 110 by controlling the gate voltages of the MOS transistors 101 to 104. Further, a predetermined voltage is input from the terminal VDD PIN and a voltage lowered to the desired value is output from the terminal VEE PIN.

In the first embodiment, the voltage level of the signal which is handled by the charge pump drive circuit is used to suitably select a PMOS transistor or NMOS transistor from the MOS transistors 101 to 104. Further, the charge pump circuit 108 and the CP control circuit 105 may also be integrated as an IC. However, the capacitor 109 may also be provided outside of the IC through the terminals (CP PIN, CN PIN), while the capacitor 110 may also be provided outside of the IC through the terminal (VEE PIN, GND PIN) .

The CP control circuit 105 is provided withaclocksignal generation circuit 106 and a control signal generation circuit 107 which changes the rising and trailing edge waveform of the branched clock signal.
According to the CP control circuit 105, the control signal generation circuit 107 can be used to gently turn the MOS transistors 101 to 104 on or off. By the MOS transistors 101 to 104 gently turning on and off, a switching current is kept from suddenly flowing due to a switching operation and the switching noise can be reduced.

### Clock Driver

Further, the control signal generation circuit 107 can also be utilized for a clock driver. Note that, here, a "clock driver" is configured to receive as input a clock signal and generate a clock signal for driving a later MOS transistor.
The clock driver which is provided with the control signal generation circuit 107 can change the rising and trailing edge waveforms of the clock signal by the control signal generation circuit 107 to gently turn an MOS transistor after the control signal generation circuit 107 on or off. By gently turning the MOS transistor on and off, the clock driver can suppress a sudden flow of switching current due to a switching operation and can reduce the switching noise.

### Control Signal Generation Circuit

The control signal generation circuit 107 of the first embodiment can reduce the amount of change of the switching current by making the rising and trailing edges of the gate voltage of the MOS transistor near the threshold voltage with the largest amount of change of current gentler.
The control signal generation circuit 107 of this first embodiment can generate four patterns of control signals including "a control signal for turning a PMOS transistor off", "a control signal for turning a PMOS transistor on", "a control signal for turning an PMOS transistor off", and "a control signal for turning an NMOS transistor on".

Below, the configuration of the control signal generation circuit 107 and the configuration and operation in the case of outputting the above four patterns of control signals will be explained.

### (1) Case of outputting control signal for turning PMOS transistor off Constitution

FIG. 2 is a view for explaining the configuration of a control signal generation circuit 107 which outputs a control signal for turning a PMOS transistor off.
The control signal generation circuit 107 is connected to a terminal of a not shown power source which supplies a power source voltage VDD (below, simply referred to as "power source voltage VDD") . Further, the control signal generation circuit 107 has constant current sources 204, 205 which supply constant currents to the node "a" which is shown by the reference symbol "a" in FIG. 2. The constant current sources 204, 205 can supply currents of the same values. Further, the control signal generation circuit 107 includes a comparator 206, three switches 201 to 203 which connect and disconnect a node "a" and constant current sources 204 and 205, and a delay part 208. The current which is supplied from the constant current source 204 and the current which is supplied from the constant current source 205 are added through the switches 201 to 203.

The switches 201 to 203 can perform switching operations so as to change the switching current IDS which flows through any of the MOS transistors 101 to 104 which are shown in FIG. 1 (in FIG. 2, referred to as "PMOS transistors") . The switches 201 to 203 are comprised of PMOS transistors.
The delay part 208 is a circuit which generates a signal which is obtained by delaying the input signal Vin. The delay part 208 includes two serially connected inverters and a capacitor which is connected in parallel to the inverters. Since the switch 202 receives as input a signal which is delayed by the delay part 208, the switch 202 operates delayed from the switch 201.

Furthermore, the control signal generation circuit 107 includes a switch 207 which connects and disconnects a terminal of a not shown power source which supplies a power source voltage VSS (below, simply referred to as "power source voltage VSS") and a node "a".
The switch 207 is comprised of an NMOS transistor. The switch 207 receives as input an input signal Vin. Since switch 207 operates complementarily with the switches 201, 202, it can output a control signal for turning a PMOS transistor on.

### Operation

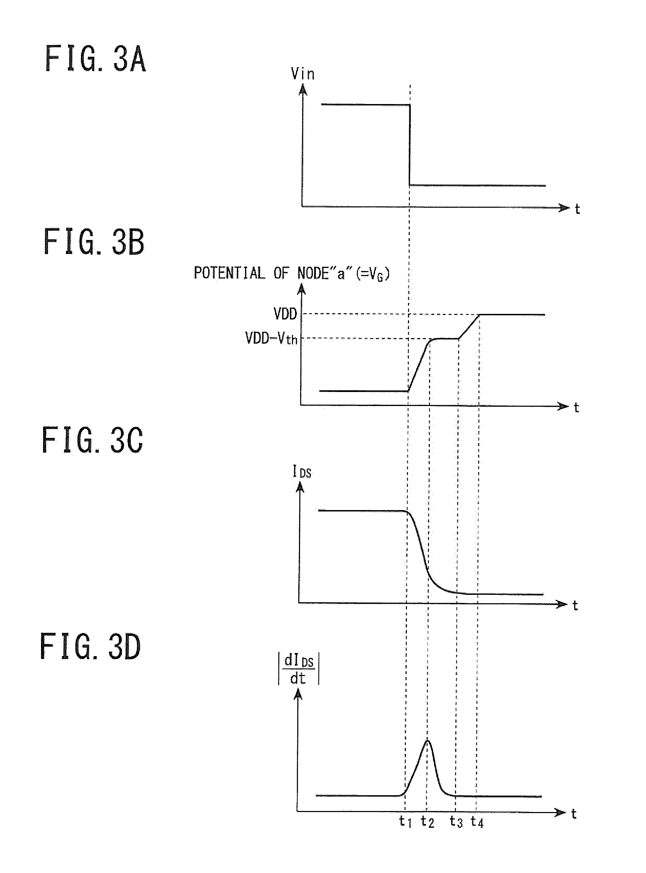

FIGS. 3A to 3D are views for explaining the operation of the control signal generation circuit 107 which is shown in FIG. 2.
FIG. 3A is a graph which shows the voltage of the input signal Vin which is input to the switches 201, 207 and delay part 208 at the ordinate and the time "t" at the abscissa. FIG. 3B is a graph which shows the potential of the node "a" which is shown at FIG. 2 at the ordinate and the time "t" at the abscissa. The potential of the node "a" becomes the voltage VG which is applied to the gate of the PMOS transistor. FIG. 3C is a graph which shows the switching current IDS which flows through the PMOS transistor at the ordinate and the time "t" at the abscissa. FIG. 3D is a graph which shows the time differential of the switching current IDS which is shown in FIG. 3C at the ordinate and the time "t" at the abscissa.

The input signal Vin is input at the switches 201, 207 and controls the switches 201, 207. The input signal Vin is input through the delay part 208 to the switch 202, and the delayed signal controls the switching of the switch 202. The voltage Vc which is input to the comparator 206 is the constant voltage (VDD-Vth). When the potential of the node "a" becomes near (VDD-Vth), the signal which is output from the comparator 206 is gradually inverted and the switch 203 gradually turns off. The threshold voltage Vth is the threshold voltage of the PMOS transistor which is shown in FIG. 2 and is the same as the threshold voltage of the PMOS transistor which forms the switch 203.

When outputting a control signal for turning a PMOS transistor off, the control signal generation circuit 107 operates in the following way.
That is, when, as shown in FIG. 3A, since the voltage of the input signal Vin is high (below, simply referred to as "H"), the switch 207 is in the on state, as shown in FIG. 3B, the potential of the node "a" becomes VSS.
Next, at the time t1, if the voltage of the input signal Vin changes from H→Low (below, simply referred to as "L"), the switch 201 is turned on and the switch 207 is turned off. At this time, the switch 203 is on in state. At this time, the switch 202 is off in state since it is switched by the signal delayed by the delay part 208.

As shown in FIG. 3B, the switches 201, 203 carry current from the constant current source 204. The gate of the PMOS transistor which is shown in FIG. 2 is charged. For this reason, the potential of the node "a" rises by a constant slant until the potential of the node "a" reaches near VDD-Vth.

Next, if, at the time t2, the potential of the node "a" reaches near VDD-Vth, Vc= (VDD-Vth), so the output signal of the comparator 206 gradually inverts and the switch 203 gradually is turned off. For this reason, the potential of the node "a" reaches near (VDD-Vth) at the time t2, then enters a floating state. For this reason, the potential of the node "a" is maintained by the gate capacity or the parasitic capacity etc. and the slant becomes substantially zero.

Next, as shown in FIG. 3B, when, at the time t3, the voltage of the signal obtained by delaying the input signal Vin changes from H →L delayed, the switch 202 is turned on. The potential of the node "a" again rises by a constant slant to VDD. Further, it reaches VDD at the time t4. As a result, in the first embodiment, the change in the gate voltage VG near VDD-Vth at the time t2 becomes gentler.

By the gate voltage being gently applied to the PMOS transistor, as shown in FIGS. 3C, 3D, the change in the switching current IDS becomes smaller before and after the time t2 when reaching the threshold voltage Vth where the MOS transistor turns off. That is, according to the first embodiment, the change in the switching current IDS is suppressed around the time t2 when reaching the threshold voltage where the PMOS transistor turns off and therefore the switching noise is reduced.

Note that, in the above operation, the voltage Vc which is input to the comparator 206 was made (VDD-Vth), but if making the change of the gate voltage VG near VDD-Vth gentle, it is sufficient to set the voltage Vc to a value close to the threshold voltage of the MOS transistor before and after (VDD-Vth) .
Further, in the above configuration, the constant current sources 204, 205 were made separate constant current sources which supply currents of the same value, but it is also possible to replace the constant current sources 204, 205 with a single constant current source.

Further, in the above configuration, the constant current sources 204, 205 were made constant current sources which supply currents of the same value, but if making the constant current source 205 supply a large value current, it is possible to shorten the period from the time t3 to the time t4. Further, if making the constant current source 204 supply a large value current, it is possible to shorten the period from the time t1 to the time t2.

Furthermore, the first embodiment is not limited to the above configuration. For example, it may also be configured without the delay part 208 which is shown in FIG. 2. In such a configuration, in the time t1 to the time t2 which are shown in FIG. 3, the switches 201, 202, and 203 turn on. At this time, the node "a" carries a current of the current which is supplied by the constant current source 204 and the current which is supplied by the constant current source 205 added together. The potential of the node "a" rises by a constant slant while a current of the current which is supplied by the constant current source 204 and the current which is supplied by the constant current source 205 added together is flowing to the node "a".

Further, at the time t2, the switch 203 turns off. At this time, since the node "a" carries only the current from the constant current source 205, the potential of the node "a" rises by a gentler slant than the slant when the current of the current which is supplied by the constant current source 204 and the current which is supplied by the constant current, source 205 added together is flowing through the node "a", and reaches VDD. As a result, the control signal generation circuit 107 without the delay circuit 208, like the control signal generation circuit 107 which is shown in FIG. 2, can make the change of the gate voltage VG near VDD-Vth at the time t2 gentler and reduce the switching noise.

### (2) Case of outputting control signal for turning PMOS transistor on Configuration

FIG. 4 is a view which explains the configuration of a control signal generation circuit 107 which outputs a control signal for turning the PMOS transistor on.
The control signal generation circuit 107 has a constant current source 405 which is connected to the power source voltage VDD and which supplies a constant current to a node and a constant current source 404 which is connected to the power source voltage VSS and which supplies a constant current to a node. The constant current sources 404, 405 are constant current sources which supply currents of the same values.

Further, the control signal generation circuit 107 includes a comparator 406, a node "b" which is shown by the reference symbol "b" in FIG. 4, three switches 401 to 403 which connect and disconnect the constant current sources 404, 405, and a delay part 408. The switches 401, 402 are comprised of PMOS transistors, while the switch403 is comprised of an PMOS transistor. Note that, the node "b" is a node which applies a voltage signal to the gate of a PMOS transistor which is shown in FIG. 4.

The delay part 408 is a circuit which generates a signal obtained by delaying the input signal Vin. The delay part 408 includes two serially connected inverters and a capacitor which is connected in parallel to the inverters. Since the switch 401 receives as input a signal which is delayed by the delay part 408, the switch 401 operates delayed from the switch 403.
Furthermore, the control signal generation circuit 107 includes a switch 407 with connects and disconnects the node "b" and the power source voltage VDD. The switch 407 is comprised of a PMOS transistor. Since the switch 407 receives as input an input signal Vin and operates complementarily with the switch 403, it can output a control signal for turning a PMOS transistor off.

### Operation

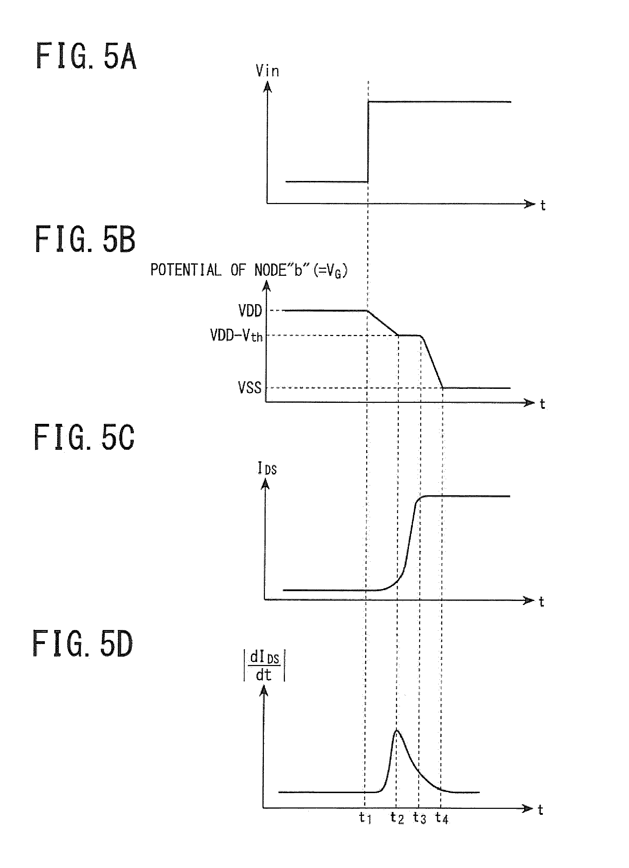

FIGS. 5A to 5D are views for explaining the operation of the control signal generation circuit 107 which is shown in FIG. 4.
FIG. 5A is a graph which shows the voltage Vin of the input signal which is input to the switches 403, 407 and delay part 408 at the ordinate and shows the time "t" at the abscissa. FIG. 5B is a graph which shows the potential of the node "b" which is shown in FIG. 4 at the ordinate and shows the time "t" at the abscissa. FIG. 5C is a graph which shows the switching current IDS which flow through the PMOS transistor at the ordinate and shows the time "t" at the abscissa. FIG. 5D is a graph which shows the time differential of the switching current IDS which is shown in FIG. 5C at the ordinate and shows the time "t" at the abscissa.

The input voltage Vin is input to the switches 403, 407 and controls the switching of the switches 403, 407. The input signal Vin is input through the delay part 408 to the switch 401. The signal which is delayed by the delay part 408 controls the switching of the switch 401. Vc is a constant voltage (VDD-Vth) . When the potential of the node "b" falls to Vc or less, the signal which is output from the comparator 406 inverts and the switch 402 turns on. The threshold voltage Vth is the threshold voltage of the PMOS transistor which is shown in FIG. 4 and is the same as the threshold voltage of the PMOS transistor which forms the switch 402.

When outputting a control signal for turning a PMOS transistor on, the control signal generation circuit 107 operates in the following way.
That is, as shown in FIG. 5A, when the voltage of the input signal Vin is "L", the switch 407 is on in state. For this reason, as shown in FIG. 5B, the potential of the node "b" becomes VDD.

Next, at the time t1, if the voltage of the input voltage Vin changes from L→H, the switch 403 turns on and the switch 407 turns off. At this time, the switch 402 is off in state. Further, since the switch 401 switches by a signal delayed by the delay part 408, it is on in state.
As shown in FIG. 5B, the switch 403 carries a current from the constant current source 404, and the gate of the PMOS transistor is discharged. For this reason, during the times t1 to t2, the potential of the node "b" drops by a constant slant.

Next, at the time t2, when the switch 403 turns on and thereby the potential of the node "b" reaches (VDD-Vth), Vc = (VDD-Vth), so the output signal of the comparator 406 inverts. Due to inversion of the output signal, the switch 402 turns on. During the times t2 to t3 where the switches 401, 402, 403 turn on, the switch 403 carries a current from the constant current source 404 and the switches 401, 402 carry a current of the same value as the current which flows from the constant current source 404, from the constant current source 405. For this reason, as shown in FIG. 5B, the potential of the node "b" is maintained at (VDD-Vth) and the slant becomes approximately zero.

Next, as shown in FTG. 5B, if, at the time 13, the signal which is obtained by delaying the input signal Vin causes the switch 401 to gradually turn off, the potential of the node "b" is current limited and again falls by a constant slant. Further, as shown in FIG. 5B, at the time t4, the potential of the node "b" reaches VSS.
As a result, as shown in FIG. 5C, the change of the switching current IDS of the PMOS transistor becomes gentler. Further, as shown in FIG. 5D, since the time differential of the switching current IDS is suppressed around the time t2 of reaching the threshold voltage VDD-Vth when the gate of the PMOS transistor turns on, the switching noise is reduced.

Note that, in the operation which is explained above, the voltage Vc which is input to the comparator 406 was made (VDD-Vth) . However, when making the change of the gate voltage VG near VDD-Vth slower, the voltage Vc may be set near the threshold value of the MOS transistor around (VDD-Vth) .

Furthermore, the first embodiment is not limited to the above configuration. For example, it may be configured without the delay part 408 which is shown in FIG. 4. In this case, the constant current source 404 is made to supply a current of a value larger than the constant current source 405, and the switch 401 is controlled by a signal of a phase reverse to the input signal Vin. At this time, from the time t1 to the time t2, the switch 403 turns on and current is supplied from the constant current source 404, so the potential of the node "b" drops by a predetermined slant. At the time t2, the switch 402 turns on, and a current which is smaller than the current of the constant current source 404 further flows from the constant current source 405. For this reason, the potential of the node "b" drops by a gentler slope than the slant by which current from the constant current source 404 flows to the node "b", and reaches VSS. As a result, the control signal generation circuit without the delay part 408, in the same way as the control signal generation circuit 107 which is shown in FIG. 4, can make the change in the gate voltage of the gate voltage VG near VDD-Vth at the time t2 gentler and reduce switching noise.

### (3) Case of outputting control signal for turning NMOS transistor off Configuration

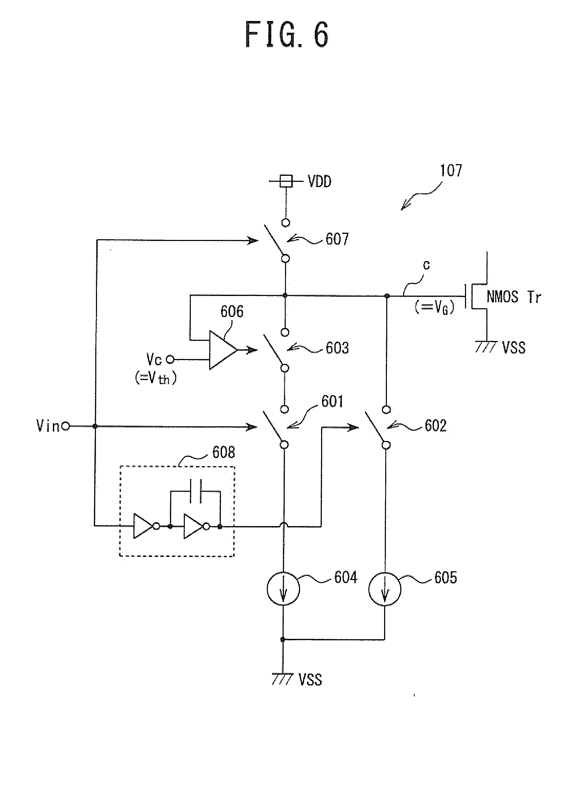

FIG. 6 is a view for explaining the configuration of a control signal generation circuit 107 which outputs a control signal for turning an NMOS transistor off.
The control signal generation circuit 107 has constant current sources 604, 605 which are connected to the power source voltage VSS and which supply constant currents to the node. The constant current sources 604, 605 can supply currents of the same values. Further, the control signal generation circuit 107 includes a comparator 606, three switches 601 to 603 which connect and disconnect the node "c" which is shown in FIG. 6 and the constant current sources 604, 605, and a delay part 608. The switches 601 to 603 are comprised of NMOS transistors.

The delay part 608 is a circuit which generates a signal which is obtained by delaying the input signal Vin. The delay part 608 includes two serially connected inverters and a capacitor which is connected in parallel to the inverters. Since the switch 602 receives as input a signal which is delayed by the delay part 608, the switch 602 operates to be delayed from the switch 601.
Furthermore, the control signal generation circuit 107 includes a switch 607 which connects and disconnects the node "c" and power source voltage VDD. The switch 607 is comprised of a PMOS transistor. Since switch 607 receives as input an input signal Vin and operates complementarily with the switches 601, 602, it can output a control signal for turning the NMOS transistor on.

### Operation

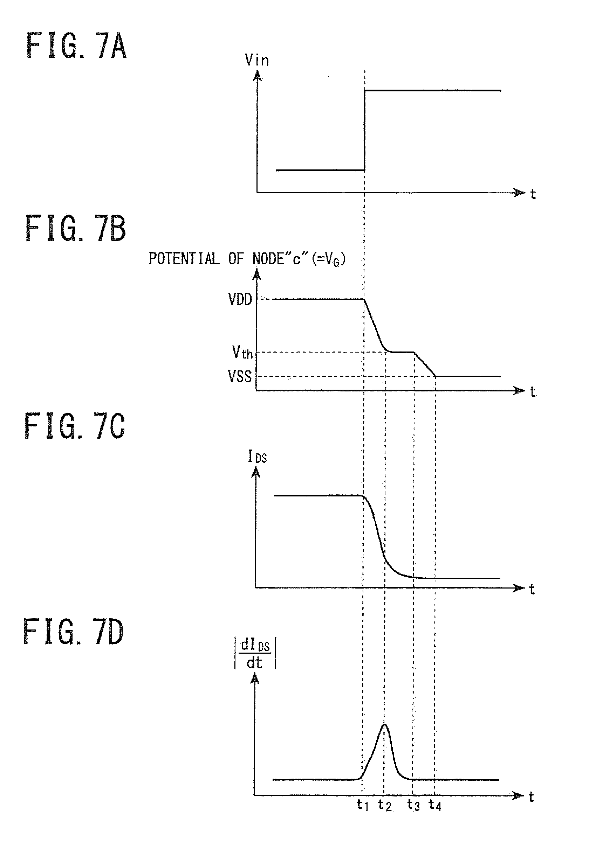

FIGS. 7A to 7D are views for explaining the operation of the control signal generation circuit 107 which is shown in FIG. 6.
FIG.7A is a graph which shows the voltage of the input signal Vin which is input to the switches 601, 607 at the ordinate and shows the time "t" at the abscissa. FIG. 7B is a graph which shows the potential of the node "c" which is shown in FIG. 6 at the ordinate and shows the time "t" at the abscissa. The potential of the node "c" becomes a voltage VG which is applied to the gate of the NMOS transistor. FIG. 7C is a graph which shows the switching current IDS which flows through the NMOS transistor at the ordinate and shows the time "t" at the abscissa. FIG. 7D is a graph which shows the time differential of the switching current IDS which is shown in FIG. 7C at the ordinate and shows the time "t" at the abscissa.

The input signal Vin is input to the switches 601, 607 and controls switching of the switches 601, 607. The input signal Vin is input through the delay part 608 to the switch 602. The signal which is delayed by the delay part 608 controls the switching of the switch 602. The Vc which is input to the comparator 606 is a constant threshold voltage Vth. If the node "c" becomes near the threshold voltage Vth, the signal which is output from the comparator 606 gradually inverts and the switch 603 is gradually turned off. The threshold voltage Vth is the threshold voltage of the NMOS transistor which is shown in FIG. 6 to the gate of which the node "c" is connected and is the same as the threshold voltage of the NMOS transistor which constitutes the switch 603.

If outputting a control signal for turning the NMOS transistor off, the control signal generation circuit 107 operates in the following way.
That is, as shown in FIG. 7A, when the voltage of the input signal Vin is L, the switch 607 becomes on in state. For this reason, as shown in FIG. 7B, the potential of the node "c" becomes VDD.

Next, if, at the time t1, the voltage of the input signal Vin changes from L→H, the switch 601 turns on and the switch 607 turns off. At this time, the switch 603 is on in state. At this time, current flows from the current source 604 to the switches 601, 603 and the gate of the NMOS transistor is discharged. Due to this, as shown in FIG. 7B, the potential of the node "c" drops.

At this time, since the switch 602 operates by a signal which is delayed by the delay part 608, it becomes off in state. For this reason, the switch 602 does not carry current from the constant current source 605.
Next, at the time t2, if the potential of the node "c" drops to near the threshold voltage Vth, Vc=Vth, the signal which is output from the comparator 606 is gradually inverted, and the switch 603 is gradually turned off. For this reason, as shown in FIG. 7B, the potential of the node "c" reaches near the threshold voltage Vth at the time t2, then enters the floating state and a slant becomes substantially zero.

As shown in FIG. 7B, if, at the time t3, the voltage of the signal obtained by delaying the input signal Vin is delayed and changes from L→H, the switch 602 is turned on. The potential of the node "c" again drops by a constant slant and drops to ASS at the time t4.
In the above way, according to the first embodiment, the change of the gate voltage VG near the threshold voltage Vth at the time t2 is made gentler.

Further, by slowly applying the gate voltage to an NMOS transistor, as shown in FIGS. 7C, 7D, the change in the switching current IDS of the NMOS transistor becomes smaller before and after the time t2. That is, according to such a configuration, the value of the switching current IDS is suppressed around the time t2 near the threshold voltage at which the NMOS transistor is turned off and the switching noise is reduced.

Note that, in the above configuration, the voltage Vc which is input to the comparator 606 was made the threshold voltage Vth, but when making the change of the gate voltage VG near the threshold voltage Vth gentler, it is sufficient to set the voltage Vc near the threshold value of the MOS transistor around the threshold voltage Vth.
Further, in the above configuration, the constant current sources 604, 605 were made separate constant current sources which supply currents of the same value, but it is also possible to replace the constant current sources 604, 605 by a single constant current source.

Further, in the above-mentioned configuration, the constant current sources 602, 605 were made constant current sources which supply currents of the same value, but if making the constant current source 605 supply a current of a large value, it is possible to shorten the time period from the time t3 to the time t4. Further, if making the constant current source 604 supply a current with a large value, it is possible to shorten the time period from the time t1 to the time t2.

Furthermore, the first embodiment is not limited to the above configuration. For example, it may also be configured without the delay part 608 which is shown in FIG. 6. At this time, from the time t1 to the time t2, the switches 601, 602, and 603 are on. At this time, the node "c" carries a current comprised of the currents of the constant current sources 602, 605 added together. The potential of the node "c" falls by a constant slant while the node "c" carries a current comprised of the currents of the constant current sources 602, 605 added together. At the time t2, the switch 603 gradually turns off, then only current from the current source 605 flows to the node "c"_{.} For this reason, the potential of the node "c" drops by a slant which is gentler than the slant when a current of the constant current sources 604, 605 added together flows to the node "c", and reaches VSS. As a result, the control signal generation circuit 107 without the delay circuit 608, in the same way as the control signal generation circuit 107 which is shown in FIG. 6, can make the change of the gate voltage VG near Vth at the time t2 gentler and reduce the switching noise.

### (4) Case of outputting control signal for turning NMOS transistor on Configuration

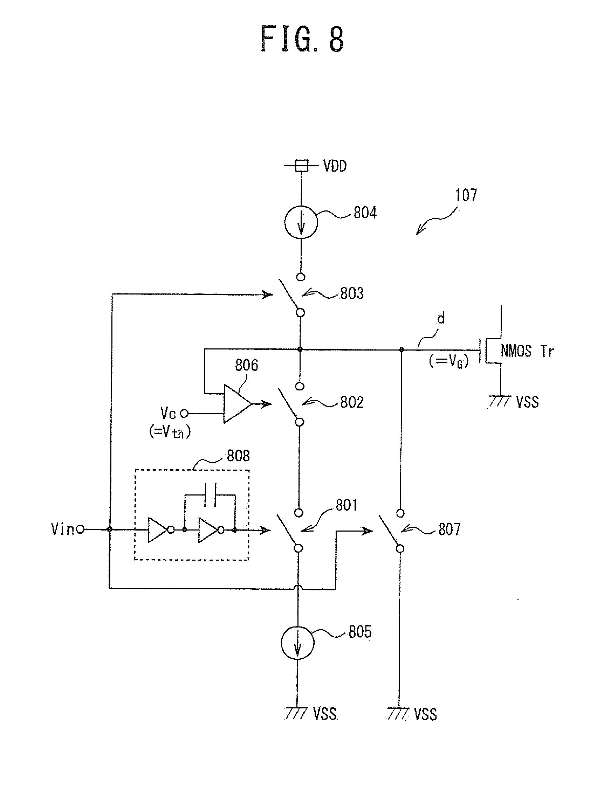

FIG. 8 is a view for explaining the configuration of a control signal generation circuit 107 which outputs a control signal for turning a NMOS transistor on.
The control signal generation circuit 107 has a constant current source 804 which is connected to the power source voltage VDD and supplies a constant current to the node and a constant current source 805 which is connected to the power source voltage VSS and supplies a constant current to the node. The constant current sources 804, 805 are made constant current sources which supply currents of the same value.

Further, the control signal generation circuit 107 includes a comparator 806, three switches 801 to 803 which connect and disconnect the node "d" to which the symbol "d" is appended in FIG. 8 and the constant current sources 804 and 805, and a delay part 808, The switches 801 and 802 are comprised of NMOS transistors, while the switch 803 is comprised of a PMOS transistor. Note that, the node "d" is a node which applies a voltage signal to the gate of the NMOS transistor which is shown in FIG. 8.

The delay part 808 is a circuit which generates a signal which is obtained by delaying the input signal Vin. The delay part 808 includes two serially connected inverters and a capacitor which is connected to the inverter in parallel. The switch 801 receives as input a signal which is delayed by the delay part 808, so that the switch 801 operates being delayed from the switch 803.
Furthermore, the control signal generation circuit 107 includes a switch 807 which connects and disconnects a node "d" and power source voltage VSS. The switch 807 is comprised of an NMOS transistor. Since the switch 807 receives as input the input voltage Vin and operates complementarily with the switch 803, it can output a control signal for turning the NMOS transistor on.

### Operation

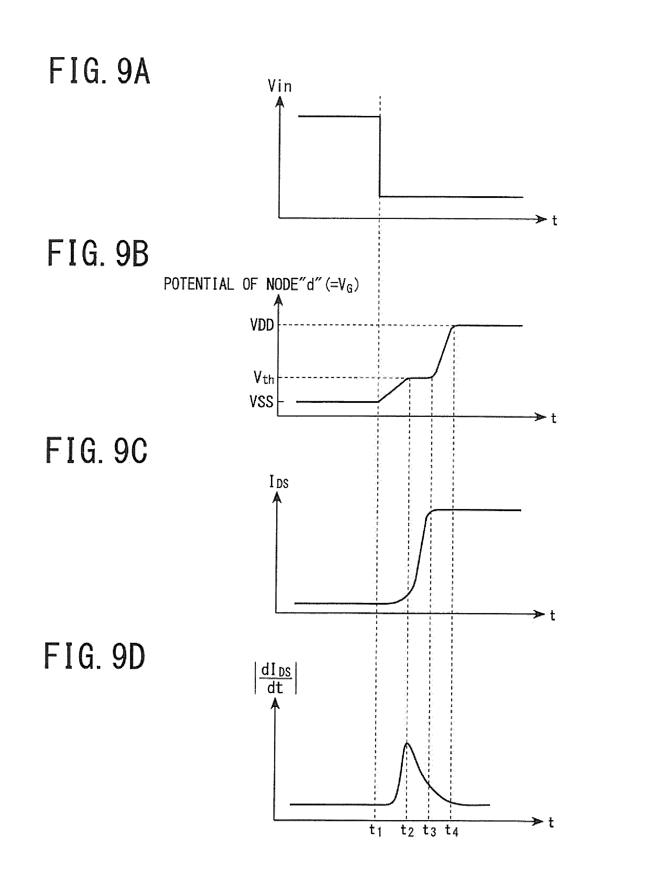

FIGS. 9A to 9D are views for explaining the operation of the control signal generation circuit 107 which is shown in FIG. 8.
FIG. 9A is a graph which shows the input voltage Vin which is input to the switches 803, 807 and delay part 808 at the ordinate and shows the time "t" at the abscissa. FIG. 9B is a graph which shows the potential of the node "d" which is shown in FIG. 8 at the ordinate and shows the time "t" at the abscissa. FIG. 9C is a graph which shows the switching current IDS which flows to a NMOS transistor at the ordinate and shows the time "t" at the abscissa. FIG. 9D is a graph which shows the time differential of the switching current IDS which is shown in FIG. 9C at the ordinate and shows the time "t" at the abscissa.

The input voltage Vin is input to the switches 803, 807 and controls the switching of the switches 803, 807. The input signal Vin is input through the delay part 808 to the switch 801. The signal which is delayed by the delay part 808 controls the switching of the switch 801. Vc is a constant threshold voltage Vth. When the potential of the node "d" rises to Vc or less, the signal which is output from the comparator 806 inverts and the switch 802 is turned on., The threshold voltage Vth is the threshold voltage of the NMOS transistor which is shown in FIG. 8.

When outputting a control signal for turning the NMOS transistor on, the control signal generation circuit 107 operates in the following way.
That is, as shown in FIG. 9A, when the input voltage Vin is H, the switch 807 becomes on, so, as shown in FIG. 8B, the potential of the node "d" becomes VSS.
Next, at the time t1, when the input voltage Vin changes from H →L, the switch 803 turns on and the switch 807 turns off. At this time, the switch 802 is in the off state. Further, since the switch 801 is switched by the signal which is delayed by the delay part 808, it is on in state. As shown in FIG. 9B, the switch 803 carries current from the constant current source 804. At this time, the gate of the NMOS transistor is charged, so that in the time period of the times t1 to t2, the potential of the node "d" rises by a constant slant.

At the time t2, if the switch803 turns on and thereby the potential of the node "d" rises to the threshold voltage Vth, the signal which is output from the comparator 806 inverts and the switch 802 is turned on.
In the time period from the times t2 to t3 where the switch 801 and the switch 803 are on, the switch 803 carries the current which is supplied from the constant current source 804. Further, the switches 801, 802 carry currents of the same value as the current which is supplied from the constant current source 804, from the constant current source 805. For this reason, as shown in FIG. 9B, the potential of the node "d" is maintained at the threshold voltage Vth and the slant becomes about zero.

Further, after the elapse of the time t3, if the signal obtained by delaying the input signal Vin is used so that the switch 801 is gradually turned off, the potential of the node "d" again rises by a constant slant while being limited in current. Further, as shown in FIG. 9B, at the time t4, the potential of the node "d" reaches VDD.
As a result, as shown in FIGS. 9C, 9D, the time differential of the switching current IDS is suppressed around the time t2 of reaching the threshold voltage Vt where the gate of the NMOS transistor turns on. For this reason, in the first embodiment, the switching noise is reduced.

Note that, in the above embodiment, the voltage Vc which is input to the comparator 806 was made the threshold voltage Vth, but when making the change of the gate voltage VG near the threshold voltage Vth gentler, it is sufficient to set the voltage Vc near the threshold value of the MOS transistor before and after the threshold voltage Vth.
Furthermore, the first embodiment is not limited to the above configuration. For example, the invention may also be configured without the delay part 808 which is shown in FIG. 8. At this time, the constant current source 804 is made one which supplies a current of a larger value than the constant current source 805, while the switch 801 is controlled by a signal of an opposite phase as the input signal Vin.

According to the above configuration, from the time t1 to the time t2, the switch 803 is on and node "d" carries a current which is supplied from the constant current source 804. While the node "d" carries a current which is supplied from the constant current source 804, the potential of the node "d" rises by a constant slant. At the time t2, the switch 802 is on and a current smaller than the current of the constant current source 804 is supplied from the constant current source 805 to the node "d" . For this reason, the potential of the node "d" rises by a gentler slant than when the node "d" carries current which is supplied from the constant current source 804, and reaches the VDD. As a result, the control signal generation circuit 107 without the delay circuit 808, in the same way as the control signal generation circuit 107 which is shown in FIG. 8, can make the change in the gate voltage VG near the threshold voltage Vth at the time t2 gentler and reduce the switching noise.

### Second Embodiment

Next, a second embodiment of the present invention will be explained.
FIG. 10 is a view for explaining a control signal generation circuit 1007 of the second embodiment. The second embodiment differs from the first embodiment in the point of controlling the PMOS transistor which is shown in FIG. 10 by a diode-connected switch. Note that, FIG. 10 illustrates the case where the control signal generation circuit 1007 outputs a control signal for turning a PMOS transistor off.

The control signal generation circuit 1007 which is shown in FIG. 10 has a switch 1003 instead of the switch 203 and comparator 206 which are shown in FIG. 2. Such a control signal generation circuit 1007 is provided with four switches 1001 to 1003, 1006, a constant current source 1004, a constant current source 1005, a delay part 1008. The switches 1001 to 1003 are comprised of PMOS transistors, while the switch 1006 is comprised of an NMOS transistor.

The switch 1003 is comprised of a PMOS transistor. The NMOS transistor which forms the switch 1003 has a gate and drain connected in common and is diode connected. The input voltage Vin is input to the switches 1001, 1002 and switch 1004. If the gate voltage VG of the PMOS transistor which is shown in FIG. 10 becomes near VDD-Vth, the VG of the switch 1003 becomes near the threshold voltage and the switch 1003 gradually turns off. As a result, even with the configuration which is shown in FIG. 10 not using a comparator, it is possible to perform an operation similar to the operation of the first embodiment of the control signal generation circuit 107 which is shown in Fig. 3.

Note that, in the second embodiment, the case of outputting a control signal for turning a PMOS transistor off is given as an example. However, the second embodiment, like the first embodiment, can use diodes to configure a control signal generation circuit which can generate any of a control signal for turning a NMOS transistor on, a control signal for turning a NMOS transistor off, or a control signal for turning a NMOS transistor on.

Further, the scope of the present invention is not limited to the illustrated and described typical embodiments and includes all embodiments which give rise to equivalent effects to those targeted by the present invention. Furthermore, the scope of the present invention is not limited to the combination of features of the invention defined by the claims and can be defined by all desired combinations of specific features among the all of the disclosed features.

### Industrial Applicability

The present invention can be applied to the entire range of circuits which generate control signals for driving charge pumps.

### Reference Signs List

105 CP control circuit
106 clock signal generation circuit
107 control signal generation circuit
109, 110 capacitor
101 to 104 MOS transistor
201 to 203, 207, 401 to 403, 407, 601 to 603, 607, 801 to 803, 807, 1001 to 1003, 1006, 1007 switch
204, 205, 404, 405, 604, 605, 804, 805, 1004, 1005 constant current source
206, 406, 606, 806 comparator
208, 408, 608, 808 delay part

## Claims

1. A control signal generation circuit which generates a control signal for controlling a gate of an MOS transistor,
the control signal generation circuit provided with
a first switching part connected to a current source and the gate and controlled based on an input signal and
a second switching part connected to the current source and the gate and controlled based on an input signal and control signal,
a voltage value of the control signal changes based on the input signal, and a slant of the voltage value with respect to time is switched to become smaller after the voltage value exceeds a threshold voltage of the MOS transistor compared with when the voltage value equals to or less than the threshold voltage of the MOS transistor.

2. The control signal generation circuit as set forth in claim 1 **characterized in that** the first switching part is provided with a first switch controlled on and off by an input signal and
the second switching part is provided with a second switch controlled on and off by an input signal and the output control part which controls the current which flows to the second switch based on the control signal.

3. The control signal generation circuit as set forth in claim 1 **characterized in that** the current source supplies currents of the same value to the first switch and second switch.

4. The control signal generation circuit as set forth in claim 1 **characterized in that** the circuit is provided with a first current source which supplies a current to the first switch and a second current source which supplies a current different in value from the current which is supplied by the first current source, to the second switch.

5. The control signal generation circuit as set forth in claim 2 **characterized in that** the output control part is provided with a comparator which compares the voltage value of the control signal and a threshold value of an MOS transistor and a third switch is controlled on/off by the results of comparison of the comparator.

6. The control signal generation circuit as set forth in claim 5 **characterized in that** the third switch stops the flow of current to the second switch when the MOS transistor changes from an on state to an off state.

7. The control signal generation circuit as set forth in claim 6 **characterized in that** the third switch supplies current which had been stopped to the second switch when the MOS transistor changes from an off state to an on state.

8. The control signal generation circuit as set forth in claim 2 **characterized in that** the output control part is provided with a diode.

9. The control signal generation circuit as set forth in claim 1 **characterized in that**
the circuit is further provided with a delay part which generates a delay signal obtained by delaying an input signal and
the first switching part operates in accordance with the delay signal and can supply current to the gate.

10. The control signal generation circuit as set forth in claim 1 **characterized in that**
the circuit is further provided with a delay part which generates a delay signal obtained by delaying an input signal and
the second switching part operates in accordance with the delay signal and can supply current to the gate.

11. A charge pump drive circuit **characterized by** being provided with
at least one control signal generation circuit as set forth in any one of claims 1 to 10,
at least one MOS transistor,
the control signal generation circuit, and
the capacitance element charged and discharged by the MOS transistor.

12. A clock driver **characterized by**
being provided with a control signal generation circuit as set forth in any one of claims 1 to 10 and
driving a MOS transistor provided later than the control signal generation circuit based on the clock signal output from the control signal generation circuit.

13. A drive method of a charge pump for driving a charge pump having at least one MOS transistor and a capacitance element which is charged and discharged by the MOS transistor,
the method comprising:
generating a control signal which changes by a slant based on the input signal, wherein the slant is switched to a smaller value when the input signal exceeds a threshold value of the MOS transistor compared to when the input signal equals to or less than a threshold value of the MOS transistor, and
supplying current to the gate of the MOS transistor based on the imput signal and the control signal.
